**Europäisches Patentamt**

**European Patent Office**

**Office européen des brevets**

(19)

(11) Publication number: **0 198 378**
A2

# (12) EUROPEAN PATENT APPLICATION

(21) Application number: **86104704.1**

(51) Int. Cl.⁴: **H 01 L 23/40**

(22) Date of filing: **07.04.86**

(30) Priority: **08.04.85 US 721242**
**12.04.85 DE 3513221**

(71) Applicant: **OTIS ELEVATOR COMPANY, Ten Farm Springs, Farmington, CT 06032 (US)**

(43) Date of publication of application: **22.10.86**
**Bulletin 86/43**

(72) Inventor: **Reimann, Kurt, Schützenstrasse 53, D-1000 Berlin 41 (DE)**

(84) Designated Contracting States: **AT BE CH DE FR GB IT LI LU NL SE**

(74) Representative: **Henkel, Feiler, Hänzel & Partner, Möhlstrasse 37, D-8000 München 80 (DE)**

(54) Apparatus for removing heat from electrical components, and method of manufacturing such apparatus.

(57) The invention relates to an apparatus for removing heat from electrical components (10), comprising a housing (14) and a heat sink (12). The heat sink (12) is mounted over an opening (16) formed in the housing, so as to completely seal said opening. On the inner side (interiorly) of the housing, the electrical component (10) is fixed to the heat sink (12) directly in the area of the opening (16).

EP 0 198 378 A2

Otis Elevator Co.

Apparatus for removing heat from electrical components, and method of manufacturing such apparatus

---

The present invention relates to an apparatus for removing (dissipating) heat from electrical components, comprising a housing and a heat sink, wherein the heat sink completely seals an opening provided in the housing, and the electrical component is mounted to the heat sink on the inner side of the housing; further, the invention relates to a method of manufacturing such an apparatus.

In power semiconductors, such as particularly thyristors and semiconductor controlled rectifiers, dissipation of the heat produced by these elements often constitutes a great problem. For example, silicon controlled rectifiers include large metal plates as electrodes, between which the semiconductor body is placed and which function also for heat dissipation in addition to power conduction. Other semiconductor power components, e.g. power transistors, are frequently mounted to the bottom plate of a special, hermetically sealed housing, in which instance the bottom plate further may have provided its outer side with cooling fins for increased heat dissipation.

As is known, power semiconductors are used also in control circuits such as, for example, in the controller for an elevator system. In this case, too, dissipation of the heat produced by the semiconductor power components plays an important role: Namely, this heat must be dissipated or removed in such a manner that the semiconductor power components can operate at the desired rated currents, and so that, further, nearby circuits are not affected thereby.

Namely, when in the case of a controller housed within a sealed housing or cabinet, sufficient heat dissipation is not provided for, this results in increased operating temperatures which require over-dimensioning of the individual components and particularly of the semiconductor power components, and this, in turn, means considerably increased cost.

Now, it could be thought of installing a blower with a filter to such a sealed housing, thereby to provide for sufficient heat dissipation, corresponding to IP 54. Such a structure would additionally require baffles to properly protect the components within the housing. In view of this, a corresponding solution to the heat dissipation problem also becomes considerably expensive.

Therefore, it is the object of the present invention to construct an apparatus of the type as outlined above, in such a manner that sufficient heat dissipation is ensured reliably without any special expenditure. Furthermore, a method of manufacturing such an apparatus should be provided.

In an apparatus of the type as outlined above, according to the present invention this object is solved in that the electrical component (or structural unit) comprises a semiconductor device mounted directly to the heat sink.

Thus, in the apparatus according to the invention, a housing which may receive a plurality of components and even circuits, is provided with an opening. This opening, in turn, is completely sealed by a heat sink, preferably on the outer side thereof. On the inner side of the housing, this heat sink has directly mounted thereto an electrical component which specifically produces heat.

Of course, it is possible to provide the housing with a plurality of such openings, and to seal or close all of these openings by heat sinks, such that all of the heat-producing electrical components may be housed within the housing in an easy manner.

In this way, particularly semiconductor power components, e.g. thyristors or controlled rectifiers, may be installed within a housing while ensuring reliable heat dissipation. Further, heat dissipation can be promoted when the heat sink is additionally provided with cooling fins on the outer side of the housing.

An advantageous method of manufacturing the apparatus according to the invention is characterized in that the opening is formed in a wall of the housing; that the opening is sealed by the heat sink; and that the component is mounted to the heat sink within the housing.

If necessary, however, it is also possible first to mount the component to the heat sink, and thereafter seal the opening by the heat sink.

Blowers, filters and baffles are not necessary, because the apparatus according to the invention provides for sufficient heat dissipation.

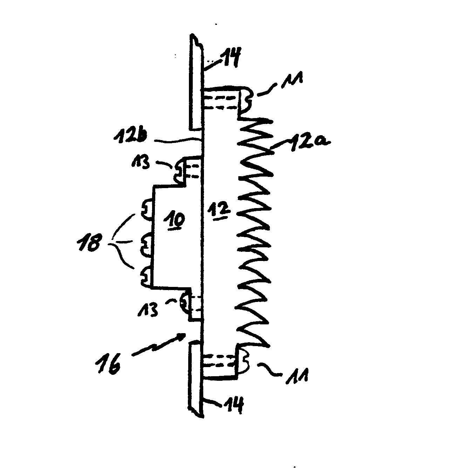

Below, an exemplary embodiment of the invention is explained in greater detail with reference to the drawing the single Figure of which illustrates the apparatus according to the invention.

A housing or cabinet having a wall 14, receives a plurality of electrical components such as, for example, a semiconductor power device 10 which may be connected to further components and electric circuits interiorly of the housing. It is also possible to dispose within the housing still further components, in addition to the semiconductor device 10. Of course, however, the semiconductor device 10 alone may be positioned within the housing.

The Figure illustrates only the (right) side wall 14 of the housing which, optionally, may be closed or sealed at the left of the Figure rearwards of the semiconductor device.

Now, it is essential that the wall 14 of the housing is provided with an opening 16 which may have, for example, a circular or square shape. Evidently, a plurality of such openings may be formed in the wall of the housing.

The opening 16 is completely sealed by a heat sink 12; here, this heat sink 12 is attached to the wall 14 by means of screws 11.

If a fully hermetically sealed housing is not necessary, the heat sink 12 is not required to completely seal the opening 16. Normally, however, opening 16 and heat sink 12 have relative dimensions such that the heat sink 12 covers the edge of the opening 16 on the outer side of the wall 14, whereby an uncomplicated and secure connection between the heat sink 12 and the wall 14 of the housing may be established by means of the screw 11.

On the surface of the heat sink 12 which faces the interior of the housing, the semiconductor device 10, which may constitute a thyristor or a controlled semiconductor rectifier, is mounted by means of screws 13.

The semiconductor device 10 has a basal surface slightly smaller than the area of the opening 16, whereby it is ensured that the semiconductor device 10 may be fixed directly to the surface of the heat sink 12 facing the interior of the housing.

Preferably, the heat sink 12 has the outer surface thereof provided with cooling fins 12a which provide for improved heat dissipation. On the other hand, the surface of the heat sink 12 facing the interior of the housing has a planar shape, thereby to ensure that the heat sink 12 sealingly closes the opening 16, and that the semiconductor device 10 may be mounted securely.

Interiorly of the housing, the semiconductor device 10 may be connected to other components through connectors 18.

Accordingly, essential to the present invention is that the wall 14 of the housing is provided with the opening 16 to which the heat sink 12 is placed in such a manner that the opening 16 is sealed hermetically. The surface of the heat sink 12 facing the interior of the housing has mounted thereto, within the area of the opening 16, the semiconductor device 10 in such a manner that the heat sink 12 is positioned on the outer side of the housing, whereas the semiconductor device 10 is positioned interiorly of the housing.

In this way, direct and positive heat dissipation of the heat produced in the semiconductor device 10 through the heat sink 12 and to the exterior is ensured, whereby over-dimensioning of the semiconductor device 10 may be avoided, and no adverse effects on components adjacent to the semiconductor device 10 interiorly of the housing need be feared.

For the manufacturing of the apparatus according to the invention, expediently the wall 14 is first provided with the opening 16. Thereafter, this opening 16 is sealed by means of the heat sink 12 in such a way that the cooling fins 12a are directed outwards, while the planar side or surface 12b of the heat sink 12 faces the interior of the housing. Then, the semiconductor device 10 is mounted to this planar side 12b. The heat sink 12 may be secured to the wall 14 by means of the screws 11, while the semiconductor device 10 may be fixed to the planar side 12b of the heat sink 12 by means of the screws 13.

Claims:

1. An apparatus for removing heat from electrical components, comprising a housing (14) and a heat sink (12), wherein the heat sink (12) completely seals an opening (16) provided in the housing (14), and the electrical component (10) is mounted to the heat sink (12) on the inner side (interiorly) of the housing (14),

characterized in that

the electrical component comprises a semiconductor device mounted directly to the heat sink (12).

2. The apparatus according to claim 1, characterized in that the semiconductor device comprises a power semiconductor component.

3. The apparatus according to claim 2, characterized in that the power component comprises a thyristor or a controlled rectifier.

4. The apparatus according to any one of claims 1 to 3, characterized in that the heat sink (12) is provided with cooling fins on the outer side (exteriorly) of the housing.

5. A method of manufacturing the apparatus according to any one of claims 1 to 4, characterized in

that the opening (16) is formed in a wall of the housing (14);

0198378

that the opening (16) is sealed by the heat sink (12); and

that the component (10) is mounted to the heat sink (12) within the housing (14).